# EUROPEAN PATENT SPECIFICATION

(11) **EP 4 216 518 B1**
(45) Date of publication and mention of the grant of the patent: **03.09.2025**
(21) Application number: 21894926.1
(22) Date of filing: 26.10.2021
(51) Int. Cl.: H04M 1/02, H01Q 1/24, H01Q 1/52, H01Q 5/364, H01Q 9/04, H05K 1/14, H05K 3/36, H03H 7/01

(54) **PRINTED CIRCUIT BOARD STRUCTURE AND ELECTRONIC DEVICE COMPRISING SAME**
LEITERPLATTENSTRUKTUR UND ELEKTRONISCHE VORRICHTUNG DAMIT
STRUCTURE DE CARTE DE CIRCUIT IMPRIMÉ ET DISPOSITIF ÉLECTRONIQUE LA COMPRENANT

(30) Priority: 18.11.2020 KR 20200154917
(43) Date of publication of application: 26.07.2023
(73) Proprietor: Samsung Electronics Co., Ltd., Suwon-si, Gyeonggi-do 16677 (KR)
(72) Inventor: PARK, Jaewoon, Suwon-si, Gyeonggi-do 16677 (KR); KANG, Sunggeun, Suwon-si, Gyeonggi-do 16677 (KR); LEE, Sungmin, Suwon-si, Gyeonggi-do 16677 (KR); LEE, Hyunwoo, Suwon-si, Gyeonggi-do 16677 (KR)
(74) Representative: Gulde & Partner
(86) International application number: PCT/KR2021/015121
(87) International publication number: WO 2022/108155

(56) References cited:
- CN-A- 107 395 788
- KR-A- 20190 029 215
- KR-A- 20190 131 760
- KR-A- 20200 100 986
- US-A1- 2017 244 818
- US-A1- 2019 261 515
- US-A1- 2019 387 649
- US-A1- 2020 303 810

## Description

### [Technical Field]

Various embodiments of the disclosure relate to a printed circuit board structure and an electronic device including the same.

### [Background Art]

While the size of electronic devices is gradually becoming smaller, as the functions of electronic devices become more diverse, it has become important to ensure a space where electronic components (e.g., a processor, a communication circuit, or a memory) for executing various functions of the electronic devices can be disposed in high density.

Recently, in order to ensure the space in which electronic components may be disposed, electronic devices including a stacked structure of multiple printed circuit boards that is configured by using an interposer have been increasing. For example, in an electronic device, a space for electronic components may be ensured by stacking multiple printed circuit boards and placing interposers including at least one via configured to electrically connecting the printed circuit boards between the stacked printed circuit boards.

An electronic device provided with an antenna and stacked printed circuit boards electrically connected via an interposer and conductive metal brackets is known from US 2019/261515 Al.

KR 2019 0131760 A discloses a similar electronic device with a stable electromagnetic shielding structure between various electrical components.

### [Disclosure of Invention]

### [Technical Problem]

Electronic components related to transmission of RF signals may be disposed on some of multiple stacked printed circuit boards.

However, when these electronic components operate in a state in connection with an unstable ground of a printed circuit board, RF signal radiation performance may be degraded by generating noise and unwanted waves.

According to an embodiment, by implementing a stable connection path with a ground for noise electronic components, it is possible to reduce antenna performance degradation.

### [Solution to Problem]

The invention is defined by the independent claims. Preferred embodiments of the invention are matter of the dependent claims.

### [Advantageous Effects of Invention]

According to various embodiments of the disclosure, by adding a stable ground connection structure for electronic components related to RF signal transmission, it is possible to reduce radiation performance degradation.

According to various embodiments of the disclosure, by connecting and using different ground areas via a separate structure, it is possible to implement antennas configured to transmit and receive signals in different frequency bands.

In addition, various effects that may be directly or indirectly appreciated through this disclosure may be provided.

### [Brief Description of Drawings]

FIG. 1 is a front perspective view of an electronic device according to an embodiment.
FIG. 2 is a rear perspective view of the electronic device of FIG. 1.
FIG. 3 is an exploded perspective view of the electronic device according to an embodiment.
FIG. 4 illustrates a printed circuit board stack structure and a connection structure.
FIG. 5A is a cross-sectional view illustrating a printed circuit board stack structure and a connection structure.
FIG. 5B illustrates a cross section of a printed circuit board stack structure including electronic components and a connection structure.
FIG. 5C illustrates the interior of an electronic device including the connection structure.
FIG. 5D is a bottom view illustrating a conductor and a structure.
FIG. 5E is a perspective view illustrating a conductor and a connection member.
FIG. 6 illustrates a printed circuit board stack structure including an antenna pattern and a connection structure.
FIG. 7 illustrates a notch filter circuit for noise removal.
FIG. 8 is a block diagram of an electronic device in a network environment according to various embodiments.

In connection with the description made with reference to the drawings, the same or substantially the same components may be denoted by the same reference numerals.

### [Mode for Carrying out the Invention]

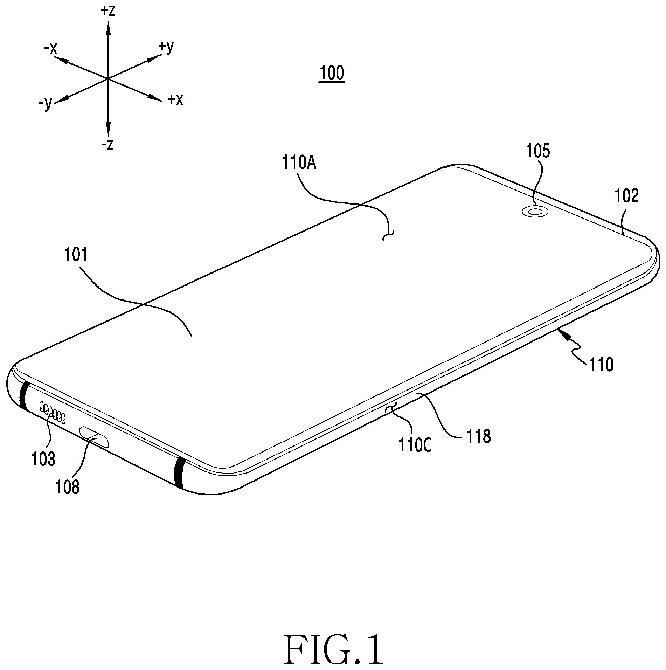

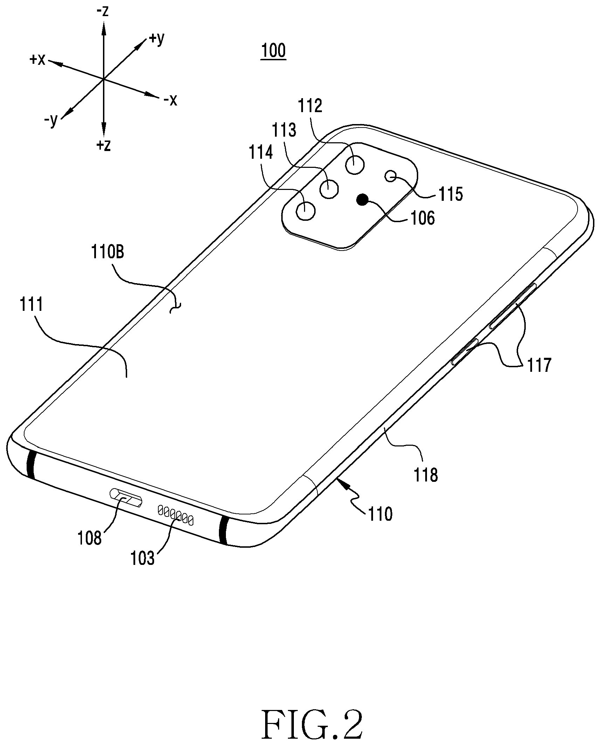

FIG. 1 is a front perspective view of an electronic device according to an embodiment, and FIG. 2 is a rear perspective view of the electronic device of FIG. 1.

Referring to FIGS. 1 and 2, an electronic device 100 according to an embodiment may include a housing 110 including a first surface (or a "front surface") 110A, a second surface (or a "rear surface") 110B, and a side surface 110C (or a "side wall") surrounding the space between the first surface 110A and the second surface 110B. In another embodiment (not illustrated), the term "housing 110" may refer to a structure defining some of the first surface 110A, the second surface 110B, and the side surface 110C of FIGS. 1 and 2.

According to an embodiment, the first surface 110A may be at least partially defined by a substantially transparent front surface plate 102 (e.g., a glass plate or a polymer plate including various coating layers). According to an embodiment, the front surface plate 102 may include a curved portion bent and seamlessly extending from the first surface 110A toward the rear surface plate 111 in at least one side edge portion.

According to an embodiment, the second surface 110B may be defined by a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. According to an embodiment, the rear surface plate 111 may include a curved portion bent and extending seamlessly from the second surface 110B toward the front surface plate 102 in at least one side edge portion.

According to an embodiment, the side surface 110C may be defined by a metal frame 118 coupled to the front surface plate 102 and the rear surface plate 111 and including metal. In an embodiment, the rear surface plate 111 and the metal frame 118 may be integrated and may include the same material (e.g., a metal material such as aluminum).

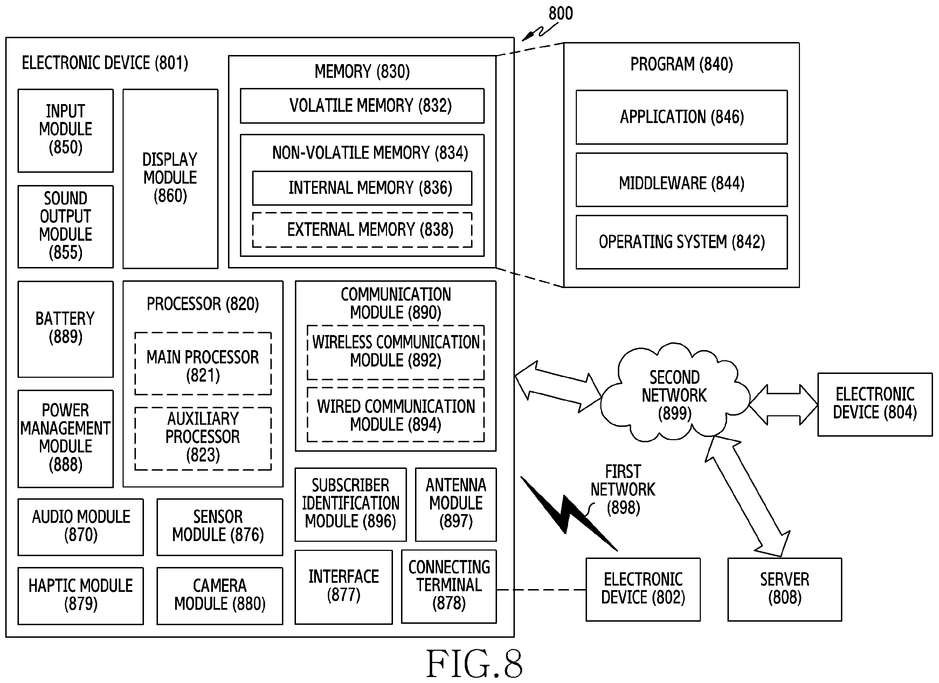

According to an embodiment, the electronic device 100 may include at least one of a display device 101 (e.g., the display module 860 in FIG. 8), an audio module 103 (e.g., the audio module 870 in FIG. 8), a sensor module (not illustrated) (e.g., the sensor module 876 in FIG. 8), camera modules 105, 112, 113, 114, and 115 (e.g., the camera module 880 in FIG. 8), a flash 106, key input devices 117 (e.g., the input device 850 in FIG. 8), and a connector hole 108 (e.g., the connection terminal 878 in FIG. 8). In an embodiment, in the electronic device 100, at least one of the components (e.g., the key input devices 117) may be omitted, or other components may be additionally included. For example, the electronic device 100 may include a sensor module (not illustrated). For example, in an area provided by the front surface plate 102, a sensor, such as a proximity sensor or an illuminance sensor, may be integrated into the display 101 or disposed at a position adjacent to the display 101. In some embodiments, the electronic device 100 may further include a light-emitting element, wherein the light-emitting element may be disposed at a position adjacent to the display 101 in the region provided by the front surface plate 102. The light-emitting element may provide, for example, the state information of the electronic device 100 in an optical form. In another embodiment, the light-emitting element may provide, for example, a light source that is interlocked with the operation of the camera module 105. The light-emitting element may include, for example, an LED, an IR LED, and a xenon lamp.

The display 101 may be visually exposed to the outside of the electronic device 100 through, for example, a substantial portion of the front surface plate 102. According to an embodiment, the edges of the display 101 may be fabricated in substantially the same shape as the outer peripheral shape (e.g., a curved surface) of the front surface plate 102 adjacent thereto. According to another embodiment (not illustrated), the distance between the outer periphery of the display 101 and the outer periphery of the front surface plate 102 may be substantially constant in order to enlarge the visually exposed area of the display 101. In another embodiment (not illustrated), an opening may be provided in a portion of a screen display area of the display 101, and other electronic components aligned with the opening, such as the camera module 105, a proximity sensor (not illustrated), or an illuminance sensor (not illustrated), may be included.

According to an embodiment, one or more camera device 105, 112, 113, 114, and 115 may be disposed under the display 101 (e.g., in the -z-axis direction). For example, a first camera device 105 may be disposed in at least a partial area of the display 101 corresponding to a camera field of view (FOV). Since the first camera device 105 is disposed in at least a partial area of the display 101 corresponding to the camera FOV, the position of the first camera device 105 may not be visually distinguished (or exposed). According to an embodiment, when the display 101 is viewed from the first surface 110A, the first camera device 105 may be disposed in a portion corresponding to the camera FOV, which is at least a portion of the display 101, and may acquire an image of an external subject without being visually exposed to the outside. For example, the first camera device 105 may be an under-display camera (UDC).

According to an embodiment, the electronic device 100 may include a display (not illustrated), which is arranged to be slidable and provides a screen (e.g., a display area). For example, the display area of the electronic device 100 may be an area that is visually exposed to output an image. In an example, in the electronic device 100, the display area is adjustable depending on the movement of the sliding plate (not illustrated) or the movement of the display. For example, the electronic device 100 may include a rollable electronic device configured to promote selective expansion of the display area by operating at least a portion of the electronic device 100 (e.g., the housing 110) to be at least partially slidable. The above-described display may be referred to as, for example, a slide-out display or an expandable display.

According to another embodiment (not illustrated), the rear surface (e.g., the second surface 110B) of the screen display area of the display 101 may include at least one of camera modules 112, 113, 114, and 115, a fingerprint sensor, and a flash 106. According to another embodiment (not illustrated), the display 101 may be coupled to or disposed adjacent to a touchsensitive circuit, a pressure sensor capable of measuring a touch intensity (pressure), and/or a digitizer configured to detect an electromagnetic field-type stylus pen.

According to an embodiment, the audio module 103 may include a microphone hole and/or a speaker hole. The microphone hole may include a microphone disposed therein so as to acquire external sound. According to an embodiment, multiple microphones may be disposed in the microphone hole so as to detect the direction of sound. According to an embodiment, the speaker hole and the microphone hole may be implemented as a single hole, or a speaker may be included without a speaker hole (e.g., a piezo speaker). For example, the speaker hole may include an external speaker hole and a call receiver hole.

According to an embodiment, by including a sensor module (not illustrated), the electronic device 100 may generate an electrical signal or a data value corresponding to an internal operating state or an external environmental condition. For example, the sensor module may further include, for example, a proximity sensor disposed on the first surface 110a of the housing 110, a fingerprint sensor incorporated in or disposed adjacent to the display 101, and/or a biometric sensor (e.g., an HRM sensor) disposed on the second surface 110B of the housing 110. According to an embodiment, the electronic device 100 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 105, 112, 113, 114, and 115 may include a first camera device 105 disposed on the first surface 110A of the electronic device 100, second camera devices 112, 113, 114, and 115 disposed on the second surface 110B thereof. For example, the above-described camera devices 105, 112, 113, 114, and 115 may include one or more lenses, an image sensor, and/or an image signal processor. According to another example, the flash 106 may include a light-emitting diode or a xenon lamp. According to an embodiment, two or more lenses (e.g., an infrared camera lens, a wide-angle lens, and a telephoto lens) and image sensors may be disposed on one surface of the electronic device 100.

According to an embodiment, key input devices 117 may be disposed on the side surface 110C of the housing 110. According to another embodiment, the electronic device 100 may not include some or all of the above-mentioned key input devices 117, and the key input devices 117, which are not included in the electronic device 101, may be implemented in another form, such as soft keys or touch keys, on the display 101. According to an embodiment, the key input devices may include at least a portion of a fingerprint sensor disposed on the second surface 110B of the housing 110.

According to an embodiment, the connector hole 108 may accommodate a connector configured to transmit and receive power and/or data to and from an external electronic device, and/or a connector configured to transmit and receive an audio signal to and from an external electronic device. For example, the connector hole 108 may include a USB connector or an earphone jack. According to an embodiment, the USB connector and the earphone jack may be implemented as a single hole (e.g., 108 in FIGS. 1 and 2), and according to another embodiment (not illustrated), the electronic device 100 may transmit and receive power and/or data or transmit and receive an audio signal to and from an external electronic device without a separate connector hole.

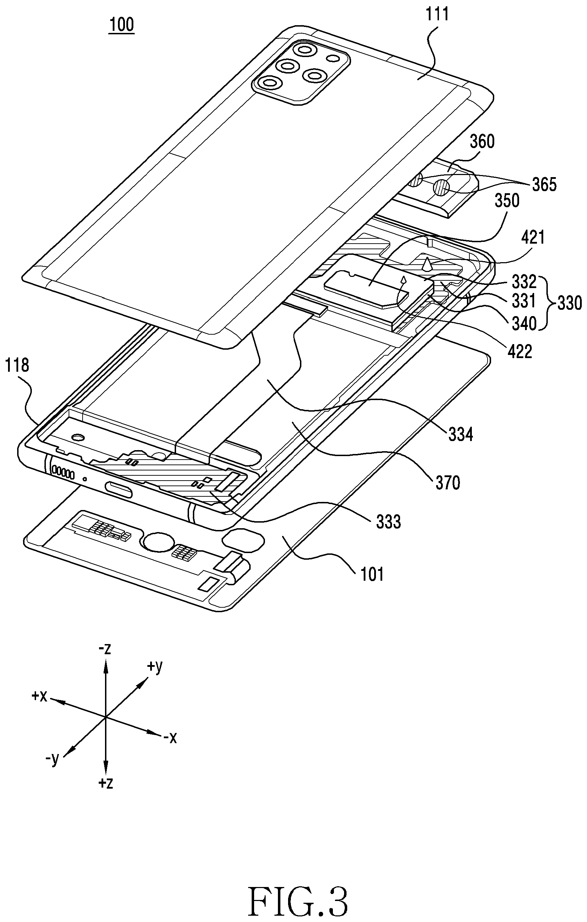

FIG. 3 is an exploded perspective view of the electronic device according to an embodiment.

Referring to FIG. 3, the electronic device 100 according to an embodiment may include a front surface plate (not illustrated) (e.g., the front surface plate 102 of FIG. 1), a display 101, a metal frame 118, a printed circuit board structure 330 (e.g., a printed circuit board (PCB), a flexible PCB (FPCB), or a rigid-flexible PCB (RFPCB)), a shield structure 350, an antenna module 360, a battery 370, and a rear surface plate 111. According to another embodiment (not illustrated), at least one of the above-described components of the electronic device 100 (e.g., the shield structure 350) may be omitted, or another component (e.g., a rear case (not illustrated)) may be added. The electronic device 100 according to an embodiment may include a first connection member 421 and a second connection member 422 on the printed circuit board structure 330, but a detailed description thereof will be described later.

According to an embodiment, the metal frame 118 may be located between the display 101 and the rear surface plate 111. For example, the metal frame 118 may be made of a conductive material (e.g., metal) to define the side surface (e.g., the side surface 110C of FIG. 1) of the electronic device 100. For example, the metal frame 118 may include at least one conductive portion and/or at least one non-conductive portion that insulates the at least one conductive portion. The at least one conductive portion of the metal frame 118 may operate as an antenna radiator that transmits and/or receives an RF signal in a predetermined frequency band.

According to an embodiment, an antenna structure may be configured with the metal frame 118. For example, an antenna (or an "antenna structure") (not illustrated) may be disposed in at least a portion of the space created by the metal frame 118. In an example, the antenna may include at least one radiation conductor (or "radiator") and may communicate a wireless signal (or an "radio frequency) signal") by being fed with power from a communication module (or a "wireless communication circuit") (e.g., the wireless communication module 892 in FIG. 8) placed on the printed circuit board structure 330. In the disclosure, communication may refer to at least one of transmission of a radio frequency signal, reception of a radio frequency signal, and/or transmission and reception of a radio frequency signal, and may be used in the same meaning below.

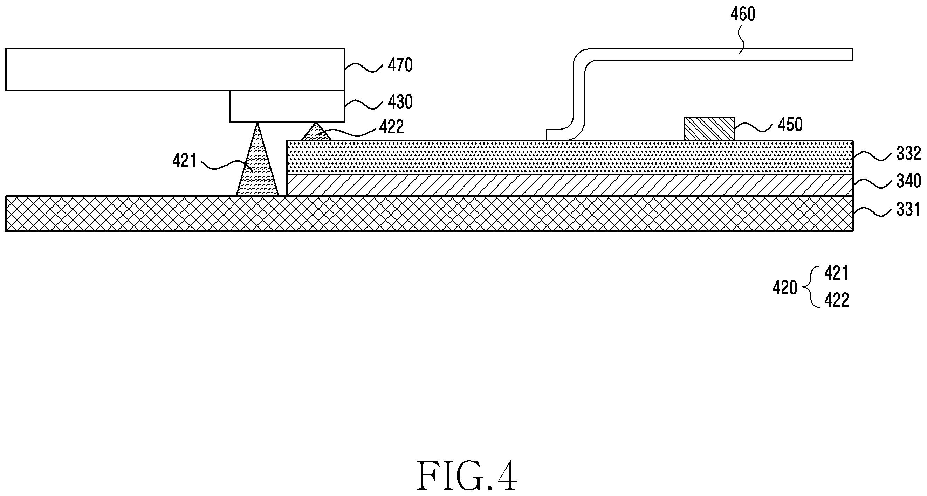

According to an embodiment, an antenna module 360 may be disposed between the rear surface plate 111 and the printed circuit board structure 330 (e.g., a printed circuit board (PCB), a flexible PCB (FPCB), or a rigid-flexible PCB (RFPCB)). For example, the antenna module 360 may include a conductive pattern. For example, the antenna module 360 may include a laser direct structure (LDS) pattern (e.g., the conductor 430 of FIG. 4) configured to be connected with the antenna radiation pattern 365.

According to an embodiment, the printed circuit board structure 330 may be disposed in at least one area inside the electronic device 100. In the disclosure, the printed circuit board structure 330 may refer to a structure in which multiple PCBs 331 and 332 are stacked. For example, the printed circuit board structure 330 may include a first PCB 331, a second PCB 332, and/or an interposer 340. As another example, the printed circuit board structure 330 may be a structure in which the interposer 340 and the second PCB 332 are stacked in order with respect to the first PCB 331.

According to an embodiment, the first PCB 331 may be disposed in at least one area inside the electronic device 100. According to an embodiment, the second PCB 332 may be spaced apart from the first PCB 331 and located in the -z direction with respect to the first PCB 331. For example, the second PCB 332 may be disposed to face one surface of the first PCB 331 facing the -z direction. According to an embodiment, the first PCB 331 and/or the second PCB 332 may be a printed circuit board (PCB) made of a material (e.g., FR4) having a nonbendable characteristic. According to another embodiment, the first PCB 331 and/or the second PCB 332 may be a flexible printed circuit board (FPCB) having a bendable characteristic (or a "flexible characteristic").

According to an embodiment, the interposer 340 may be located between the first PCB 331 and the second PCB 332 and coupled to the first PCB 331 and the second PCB 332. For example, the interposer 340 may be disposed to surround a space between the first PCB 331 and the second PCB 332. According to an embodiment, the first PCB 331 and the second PCB 332 may be electrically connected to each other via at least one conductive via in the interposer 340.

According to an embodiment, multiple electronic components may be disposed on the first PCB 331 and/or the second PCB 332 of the printed circuit board structure 330. For example, a processor (e.g., the processor 820 in FIG. 8), a memory (e.g., the memory 830 in FIG. 8), a control circuit, and/or an interface (e.g., the interface 877 in FIG. 8) may be disposed on the first PCB 331 and/or the second PCB 332. For example, a radio frequency integrated circuit (RFIC) may be disposed on the second PCB 332. According to an example, the multiple electronic components disposed on the first PCB 331 and the multiple electronic components disposed on the second PCB 332 may be electrically and/or operatively connected to each other via the interposer 340. According to an embodiment, the multiple electronic components disposed on the first PCB 331 and the electronic components disposed on the second PCB 332 may be electrically connected to each other via a separate connection structure. This will be described in detail later.

According to an embodiment, the first PCB 331 and/or the second PCB 332 of the printed circuit board structure 330 may be electrically connected to the third PCB 333 disposed apart from the printed circuit board structure 330. According to an embodiment, the first PCB 331 and/or the second PCB 332 and the third PCB 333 may be electrically connected to each other via a connection member 334. For example, the connection member 334 may electrically connect the first PCB 331 and/or the second PCB 332 and the third PCB 333 to each other across the disposed battery 370. For example, the connection member 334 may include at least one of a flexible printed circuit board (FPCB), a coaxial cable, and a board to board (B to B) connector, but is not limited thereto.

According to an embodiment, the printed circuit board structure 330 may include an area having a bendable or flexible characteristic (hereinafter referred to as a "flexible area"). In an example, the flexible area may include a base film (or a substrate) and a copper foil layer. For example, the flexible area may be a flexible copper clad layer (FCCL) in which at least one copper clad is stacked on at least a portion of at least one area of the top or bottom of a polyimide film.

According to an embodiment, the shield structure 350 (or a "shield can") may be made of a conductive material (e.g., metal) and may be disposed in at least one area of the printed circuit board structure 330 to electromagnetically shield the multiple electronic components disposed on the printed circuit board structure 330. In an example, the shield structure 350 may be at least partially disposed on the second PCB 332 of the printed circuit board structure 330, and may electromagnetically shield the multiple electronic components disposed on the second PCB 332.

According to an embodiment, a rear case (not illustrated) may be disposed on the -z direction of the printed circuit board structure 330 to protect the printed circuit board structure 330 and the multiple electronic components disposed on the printed circuit board structure 330 from an external force applied to the electronic device 100. For example, the rear case (not illustrated) may be made of a non-conductive material (e.g., plastic), but is not limited thereto. In an electronic device 100 according to another embodiment (not illustrated), the rear case 360 may be omitted.

According to an embodiment, the battery 370 may be disposed inside the electronic device 100 to supply power to at least one component of the electronic device 100. The battery 370 may include, for example, a non-rechargeable primary battery, a rechargeable secondary battery, or a fuel cell. According to an embodiment, the battery 370 may be integrally disposed inside the electronic device 100, but is not limited thereto. According to another embodiment, the battery 370 may be detachably attached to the electronic device 100.

According to an embodiment, the rear surface plate 111 may define the rear surface (e.g., the second surface 110B of FIG. 2) of the electronic device 100. The rear surface plate 111 may protect the internal components of the electronic device 100 from an external impact or inflow of foreign substances.

FIG. 4 illustrates a printed circuit board stack structure and a connection structure.

Referring to FIG. 4, the printed circuit board stack structure according to an embodiment may include a first PCB 331, a second PCB 332 disposed in parallel to the first PCB 331, an interposer 340 disposed between the first PCB 331 and the second PCB 332, multiple connection members 420, a conductor 430, a shield structure 460, and a structure 470. According to an embodiment, the interposer 340 may surround a space between the first PCB 331 and the second PCB 332. According to another embodiment, some of the above-described components (e.g., the structure 470 and the shield structure 460) may be omitted and other components may be added. The same reference numerals are used for the same or substantially the same components as those described above, and redundant descriptions are omitted.

According to an embodiment, the structure 470 and the conductor 430 may be integrated. For example, the conductor 430 may be a pattern provided on the structure 470 by using a laser direct structure (LDS) method. As another example, the structure 470 and the conductor 430 may be integrated on a printed circuit board (e.g., a printed circuit board (PCB), a flexible PCB (FPCB), or a rigid-flexible PCB (RFPCB)). For example, the conductor 430 may be at least one conductive layer of the structure 470 (e.g., a printed circuit board).

According to an embodiment, the first PCB 331 may have a first size, and the second PCB 332 may have a second size smaller than the first size. According to an embodiment, the first PCB 331 may include a first area corresponding to the second PCB 332 and a second area excluding the first area. According to an embodiment, the interposer 340 may be disposed between the first area of the first PCB 331 and the second PCB 332. For example, the interposer 340 may be disposed to surround a space between the first area of the first PCB 331 and the second PCB 332.

According to an embodiment, the multiple connection members 420 may include a first connection member 421 and a second connection member 422. According to an embodiment, the first connection member 421 may be coupled to the first PCB 331. According to an embodiment, the first connection member 421 may be electrically connected to the first ground of the first PCB 331. According to an embodiment, the first connection member 421 may be connected to the first ground of the first PCB 331 and the conductor 430. According to an embodiment, the second connection member 422 may be coupled to the second PCB 332. According to an embodiment, the second connection member 422 may be electrically connected to the second ground of the second PCB 332. According to an embodiment, the second connection member 422 may be connected to the conductor 430 and the second ground.

According to an embodiment, the first connection member 421 and the second connection member 422 may be made of a conductive material (e.g., metal). According to an embodiment, the first connection member 421 and the second connection member 422 may be connected to the conductor 430 to provide an electrical path. For example, the second ground may be electrically connected to the first ground via the second connection member 422, the conductor 430, and the first connection member 421. According to another embodiment, the first connection member 421, the second connection member 422, and the conductor 430 may be integrated.

According to an embodiment, at least one electronic component 450 may be disposed on one surface of the second PCB 332. According to an embodiment, the at least one electronic component 450 may include a noise electronic component that generates noise. According to an embodiment, the at least one electronic component 450 may include a component that transmits or receives an RF signal. For example, the at least one electronic component 450 may include at least one of an RF power amplifier module (PAM) and an attenuator.

According to an embodiment, the at least one electronic component 450 may be electrically connected to the first ground. According to an embodiment, the at least one electronic component 450 may be electrically connected to the first ground via the second connection member 422, the conductor 430, and the first connection member 421.

According to another embodiment, the at least one electronic component 450 may be disposed in the second area of the first PCB 331. In an example, the at least one electronic component 450 disposed in the second area of the first PCB 331 may include an anti-noise electronic component (e.g., a battery) that does not generate noise.

According to an embodiment, the structure 470 may define at least a portion of a housing of an electronic device (e.g., the electronic device 100 of FIG. 1).

According to an embodiment, the shield structure 460 may be made of a conductive material (e.g., metal). According to an embodiment, the shield structure 460 may be at least partially disposed on the second PCB 332 of the printed circuit board structure 330, and may electromagnetically shield the multiple electronic components disposed on the second PCB 332. According to an embodiment, the shield structure 460 may be disposed in at least one area of the second PCB 332 to electromagnetically shield the multiple electronic components disposed on the second PCB 332.

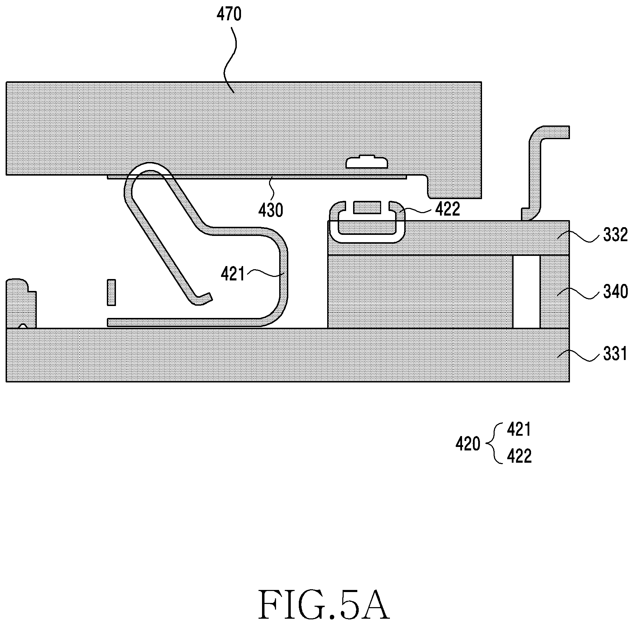

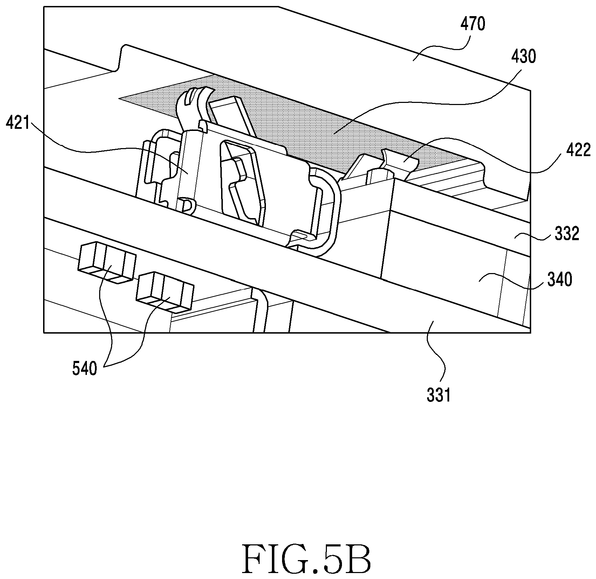

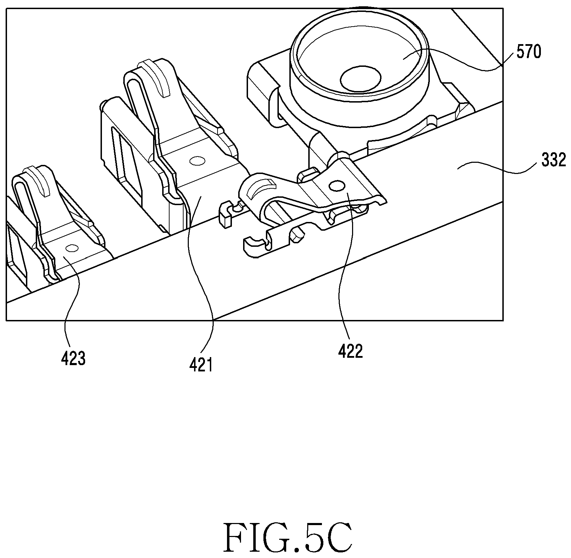

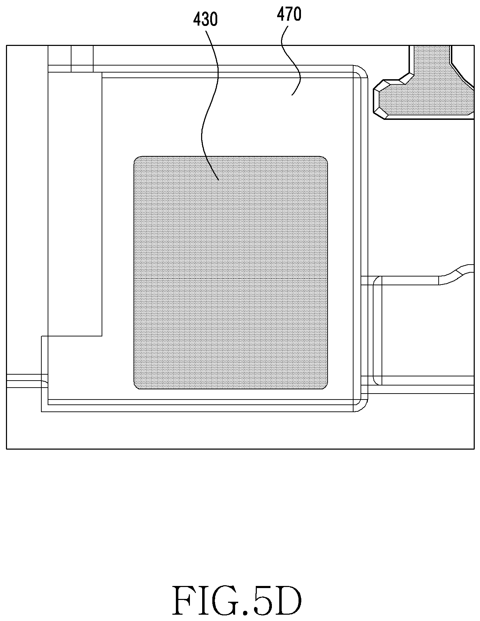

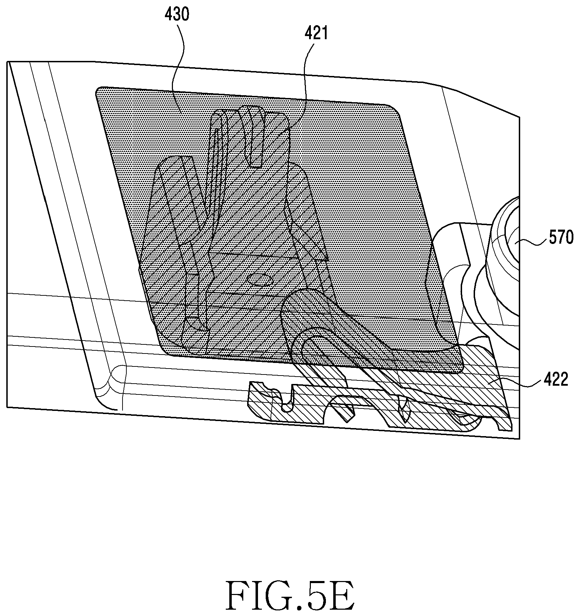

FIG. 5A is a cross-sectional view illustrating a printed circuit board stack structure and a connection structure. FIG. 5B illustrates a cross section of a printed circuit board stack structure including electronic components and a connection structure. FIG. 5C illustrates the interior of an electronic device including the connection structure. FIG. 5D is a bottom view illustrating a conductor and a structure. FIG. 5E is a perspective view illustrating a conductor and a connection member.

Referring to FIGS. 5A to 5E, an electronic device (e.g., the electronic device 100 of FIG. 1) according to an embodiment may include a printed circuit board structure (e.g., the printed circuit board structure 330 of FIG. 3), a first connection member 421, a second connection member 422, a third connection member 423, a conductor 430, and a structure 470. According to another embodiment (not illustrated), some of the above-mentioned components (e.g., the structure 470 and the third connection member 423) may be omitted and other components may be added. The same reference numerals are used for the same or substantially the same components as those described above, and redundant descriptions are omitted.

According to an embodiment, the first connection member 421 and/or the second connection member 422 may come into elastic contact with the conductor 430. For example, the first connection member 421 and the second connection member 422 may include a c-clip.

According to another embodiment, the first connection member 421 and/or the second connection member 422 may be connected to the conductor 430 via the structure 470. According to an embodiment, the structure 470 may include at least one groove, and the multiple connection members 420 may include protrusions. For example, by inserting the protrusions of the multiple connection members 420 into at least one groove disposed in the structure 470, the multiple connection members 420 may come into contact with the conductor 430.

According to an embodiment, the at least one electronic component 540 may be disposed on one surface of the first PCB 331. According to an embodiment, the at least one electronic component 540 may be disposed in an area of the first PCB 331 that does not correspond to the second PCB 332. According to an embodiment, the at least one electronic component 540 may include an anti-noise electronic component (e.g., a battery) that does not generate noise.

According to an embodiment, the electronic device may include a camera structure 570 (e.g., the camera module 880 of FIG. 8). According to an embodiment, the first connection member 421 and/or the second connection member 422 may be disposed adjacent to the camera structure 570, but is not limited thereto.

According to an embodiment, the conductor 430 may be attached to one surface of the structure 470. According to an embodiment, the conductor 430 may be disposed such that at least a portion of the conductor 430 overlaps the structure 470.

According to an embodiment, the conductor 430 may include a conductive pattern. For example, the conductor 430 may include a laser direct structure (LDS) pattern to be connected with an antenna radiation pattern (e.g., the antenna radiation pattern 365 of FIG. 3). A detailed description thereof will be given later.

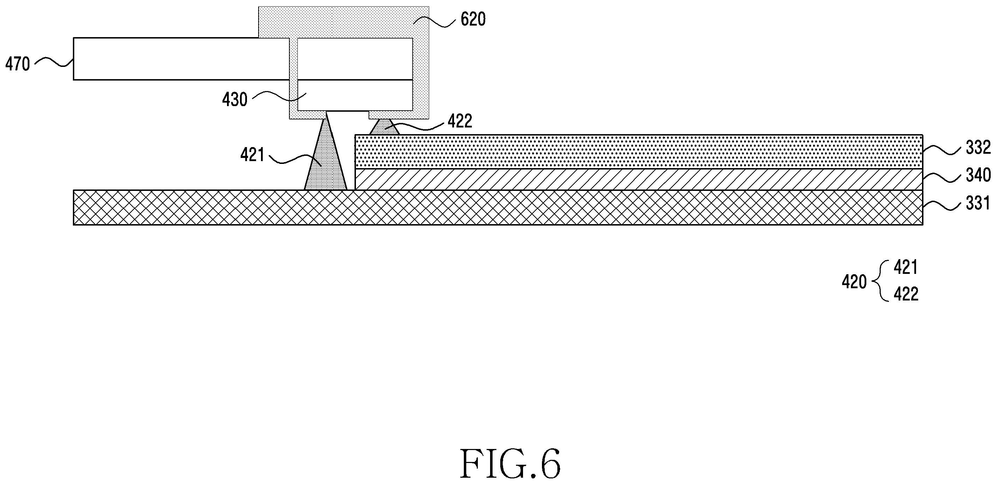

FIG. 6 illustrates a printed circuit board stack structure including an antenna pattern and a connection structure.

Referring to FIG. 6, an electronic device (e.g., the electronic device 100 in FIG. 1) according to an embodiment may include a first PCB 331, a second PCB 332 disposed in parallel to the first PCB 331, an interposer 340 disposed between the first PCB 331 and the second PCB 332, multiple connection members 420, a conductor 430, an antenna pattern 620, and a structure 470. The same reference numerals are used for the same or substantially the same components as those described above, and redundant descriptions are omitted.

The conductor 430 and the antenna pattern 620 may be disposed on one surface of the structure 470. According to the invention as claimed, the conductor 430 is disposed on one surface of the structure 470, and the antenna pattern 620 may be disposed on the other surface of the structure 470. According to an embodiment, the conductor 430 and/or the antenna pattern 620 may include a conductive pattern. For example, the conductor 430 and/or the antenna pattern 620 may include an LDS antenna pattern.

According to an embodiment, the conductor 430 and/or the antenna pattern 620 may be electrically connected to at least one of a first ground of the first PCB 331 and a second ground of the second PCB 332. According to an embodiment, the conductor 430 and/or the antenna pattern 620 may be connected to the first ground and the second ground via the first connection member 421 and the second connection member 422. According to the invention as claimed, the conductor 430 and the antenna pattern 620 are electrically connected to the first ground of the first PCB 331 via the first connection member 421.

According to an embodiment, an electronic device may include a wireless communication circuit (e.g., the wireless communication module 892 of FIG. 8). According to an embodiment, the wireless communication circuit may be electrically connected to the conductor 430 and/or the antenna pattern 620. According to an embodiment, the wireless communication circuit may feed power to the conductor 430 and/or the antenna pattern 620. According to an embodiment, the wireless communication circuit may transmit or receive a signal in a predetermined frequency band by feeding power to the conductor 430 and/or the antenna pattern 620.

According to an embodiment, the wireless communication circuit may transmit and receive a signal in a first frequency band by feeding power to the conductor 430. For example, the wireless communication circuit may transmit and receive a signal having a frequency of 850 MHz by feeding power to the conductor 430. According to an embodiment, the wireless communication circuit may transmit and receive a first signal in a first frequency band by feeding power to the conductor 430 and may transmit and receive a second signal in a second frequency band distinct from the first frequency band by feeding power to the antenna pattern 620. For example, the wireless communication circuit may transmit and receive a signal in the 850 MHz frequency band by feeding power to the conductor 430 and may transmit and receive a signal in the 1.8 GHz frequency band by feeding power to the antenna pattern 620, but are not limited thereto.

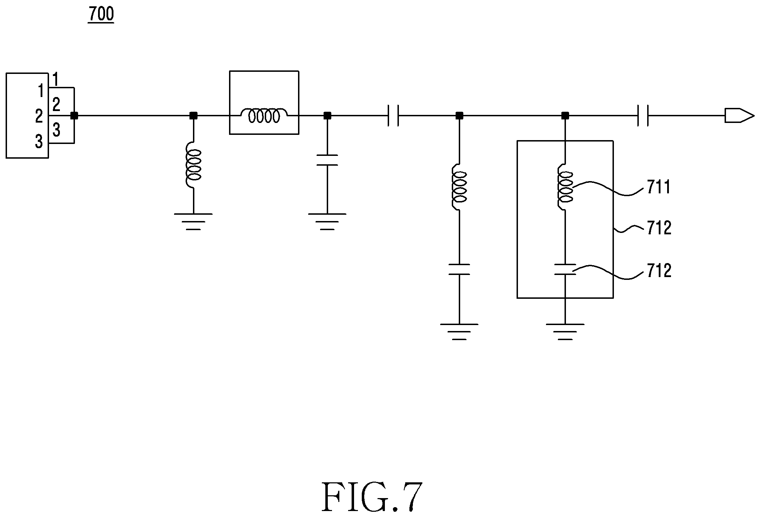

FIG. 7 illustrates a notch filter circuit for noise removal.

Referring to FIGS. 6 and 7 together, an electronic device (e.g., the electronic device 100 of FIG. 1) according to an embodiment may include a conductor 430, an antenna pattern 620, a notch filter circuit 700, and a wireless communication circuit (e.g., the wireless communication module 892 of FIG. 8). According to an embodiment, the notch filter circuit 700 may include at least one passive element 710. According to an embodiment, the notch filter circuit 700 may include at least one inductor 711 and at least one capacitor 712. The same reference numerals are used for the same or substantially the same components as those described above, and redundant descriptions are omitted.

According to an embodiment, the notch filter circuit 700 may be electrically connected to the wireless communication circuit. According to an embodiment, the notch filter circuit 700 may block a signal in a predetermined frequency band. According to an embodiment, the notch filter circuit 700 may block a signal in a predetermined frequency band generated via the conductor 430 and/or the antenna pattern 620. For example, the notch filter circuit 700 may block a signal in a third frequency band generated via the antenna pattern 620.

Fig. 8 is a block diagram illustrating an electronic device 801 in a network environment 800 according to various embodiments. Referring to Fig. 8, the electronic device 801 in the network environment 800 may communicate with an electronic device 802 via a first network 898 (e.g., a short-range wireless communication network), or at least one of an electronic device 804 or a server 808 via a second network 899 (e.g., a long-range wireless communication network). According to an embodiment, the electronic device 801 may communicate with the electronic device 804 via the server 808. According to an embodiment, the electronic device 801 may include a processor 820, memory 830, an input module 850, a sound output module 855, a display module 860, an audio module 870, a sensor module 876, an interface 877, a connecting terminal 878, a haptic module 879, a camera module 880, a power management module 888, a battery 889, a communication module 890, a subscriber identification module (SIM) 896, or an antenna module 897. **In** some embodiments, at least one of the components (e.g., the connecting terminal 878) may be omitted from the electronic device 801, or one or more other components may be added in the electronic device 801. **In** some embodiments, some of the components (e.g., the sensor module 876, the camera module 880, or the antenna module 897) may be implemented as a single component (e.g., the display module 860).

The processor 820 may execute, for example, software (e.g., a program 840) to control at least one other component (e.g., a hardware or software component) of the electronic device 801 coupled with the processor 820, and may perform various data processing or computation. According to one embodiment, as at least part of the data processing or computation, the processor 820 may store a command or data received from another component (e.g., the sensor module 876 or the communication module 890) in volatile memory 832, process the command or the data stored in the volatile memory 832, and store resulting data in non-volatile memory 834. According to an embodiment, the processor 820 may include a main processor 821 (e.g., a central processing unit (CPU) or an application processor (AP)), or an auxiliary processor 823 (e.g., a graphics processing unit (GPU), a neural processing unit (NPU), an image signal processor (ISP), a sensor hub processor, or a communication processor (CP)) that is operable independently from, or in conjunction with, the main processor 821. For example, when the electronic device 801 includes the main processor 821 and the auxiliary processor 823, the auxiliary processor 823 may be adapted to consume less power than the main processor 821, or to be specific to a specified function. The auxiliary processor 823 may be implemented as separate from, or as part of the main processor 821.

The auxiliary processor 823 may control at least some of functions or states related to at least one component (e.g., the display module 860, the sensor module 876, or the communication module 890) among the components of the electronic device 801, instead of the main processor 821 while the main processor 821 is in an inactive (e.g., sleep) state, or together with the main processor 821 while the main processor 821 is in an active state (e.g., executing an application). According to an embodiment, the auxiliary processor 823 (e.g., an image signal processor or a communication processor) may be implemented as part of another component (e.g., the camera module 880 or the communication module 890) functionally related to the auxiliary processor 823. According to an embodiment, the auxiliary processor 823 (e.g., the neural processing unit) may include a hardware structure specified for artificial intelligence model processing. An artificial intelligence model may be generated by machine learning. Such learning may be performed, e.g., by the electronic device 801 where the artificial intelligence is performed or via a separate server (e.g., the server 808). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 830 may store various data used by at least one component (e.g., the processor 820 or the sensor module 876) of the electronic device 801. The various data may include, for example, software (e.g., the program 840) and input data or output data for a command related thereto. The memory 830 may include the volatile memory 832 or the non-volatile memory 834.

The program 840 may be stored in the memory 830 as software, and may include, for example, an operating system (OS) 842, middleware 844, or an application 846.

The input module 850 may receive a command or data to be used by another component (e.g., the processor 820) of the electronic device 801, from the outside (e.g., a user) of the electronic device 801. The input module 850 may include, for example, a microphone, a mouse, a keyboard, a key (e.g., a button), or a digital pen (e.g., a stylus pen).

The sound output module 855 may output sound signals to the outside of the electronic device 801. The sound output module 855 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 860 may visually provide information to the outside (e.g., a user) of the electronic device 801. The display module 860 may include, for example, a display, a hologram device, or a projector and control circuitry to control a corresponding one of the display, hologram device, and projector. According to an embodiment, the display module 860 may include a touch sensor adapted to detect a touch, or a pressure sensor adapted to measure the intensity of force incurred by the touch.

The audio module 870 may convert a sound into an electrical signal and vice versa. According to an embodiment, the audio module 870 may obtain the sound via the input module 850, or output the sound via the sound output module 855 or a headphone of an external electronic device (e.g., an electronic device 802) directly (e.g., wiredly) or wirelessly coupled with the electronic device 801.

The sensor module 876 may detect an operational state (e.g., power or temperature) of the electronic device 801 or an environmental state (e.g., a state of a user) external to the electronic device 801, and then generate an electrical signal or data value corresponding to the detected state. According to an embodiment, the sensor module 876 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 877 may support one or more specified protocols to be used for the electronic device 801 to be coupled with the external electronic device (e.g., the electronic device 802) directly (e.g., wiredly) or wirelessly. According to an embodiment, the interface 877 may include, for example, a high definition multimedia interface (HDMI), a universal serial bus (USB) interface, a secure digital (SD) card interface, or an audio interface.

A connecting terminal 878 may include a connector via which the electronic device 801 may be physically connected with the external electronic device (e.g., the electronic device 802). According to an embodiment, the connecting terminal 878 may include, for example, a HDMI connector, a USB connector, a SD card connector, or an audio connector (e.g., a headphone connector).

The haptic module 879 may convert an electrical signal into a mechanical stimulus (e.g., a vibration or a movement) or electrical stimulus which may be recognized by a user via his tactile sensation or kinesthetic sensation. According to an embodiment, the haptic module 879 may include, for example, a motor, a piezoelectric element, or an electric stimulator.

The camera module 880 may capture a still image or moving images. According to an embodiment, the camera module 880 may include one or more lenses, image sensors, image signal processors, or flashes.

The power management module 888 may manage power supplied to the electronic device 801. According to one embodiment, the power management module 888 may be implemented as at least part of, for example, a power management integrated circuit (PMIC).

The battery 889 may supply power to at least one component of the electronic device 801. According to an embodiment, the battery 889 may include, for example, a primary cell which is not rechargeable, a secondary cell which is rechargeable, or a fuel cell.

The communication module 890 may support establishing a direct (e.g., wired) communication channel or a wireless communication channel between the electronic device 801 and the external electronic device (e.g., the electronic device 802, the electronic device 804, or the server 808) and performing communication via the established communication channel. The communication module 890 may include one or more communication processors that are operable independently from the processor 820 (e.g., the application processor (AP)) and supports a direct (e.g., wired) communication or a wireless communication. According to an embodiment, the communication module 890 may include a wireless communication module 892 (e.g., a cellular communication module, a short-range wireless communication module, or a global navigation satellite system (GNSS) communication module) or a wired communication module 894 (e.g., a local area network (LAN) communication module or a power line communication (PLC) module). A corresponding one of these communication modules may communicate with the external electronic device via the first network 898 (e.g., a short-range communication network, such as Bluetooth^{™}, wireless-fidelity (Wi-Fi) direct, or infrared data association (IrDA)) or the second network 899 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 892 may identify and authenticate the electronic device 801 in a communication network, such as the first network 898 or the second network 899, using subscriber information (e.g., international mobile subscriber identity (IMSI)) stored in the subscriber identification module 896.

The wireless communication module 892 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 892 may support a high-frequency band (e.g., the mmWave band) to achieve, e.g., a high data transmission rate. The wireless communication module 892 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 892 may support various requirements specified in the electronic device 801, an external electronic device (e.g., the electronic device 804), or a network system (e.g., the second network 899). According to an embodiment, the wireless communication module 892 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 897 may transmit or receive a signal or power to or from the outside (e.g., the external electronic device) of the electronic device 801. According to an embodiment, the antenna module 897 may include an antenna including a radiating element composed of a conductive material or a conductive pattern formed in or on a substrate (e.g., a printed circuit board (PCB)). According to an embodiment, the antenna module 897 may include a plurality of antennas (e.g., array antennas). In such a case, at least one antenna appropriate for a communication scheme used in the communication network, such as the first network 898 or the second network 899, may be selected, for example, by the communication module 890 (e.g., the wireless communication module 892) from the plurality of antennas. The signal or the power may then be transmitted or received between the communication module 890 and the external electronic device via the selected at least one antenna. According to an embodiment, another component (e.g., a radio frequency integrated circuit (RFIC)) other than the radiating element may be additionally formed as part of the antenna module 897.

According to various embodiments, the antenna module 897 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 801 and the external electronic device 804 via the server 808 coupled with the second network 899. Each of the electronic devices 802 or 804 may be a device of a same type as, or a different type, from the electronic device 801. According to an embodiment, all or some of operations to be executed at the electronic device 801 may be executed at one or more of the external electronic devices 802, 804, or 808. For example, if the electronic device 801 should perform a function or a service automatically, or in response to a request from a user or another device, the electronic device 801, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 801. The electronic device 801 may provide the outcome, with or without further processing of the outcome, as at least part of a reply to the request. To that end, a cloud computing, distributed computing, mobile edge computing (MEC), or client-server computing technology may be used, for example. The electronic device 801 may provide ultra low-latency services using, e.g., distributed computing or mobile edge computing. In another embodiment, the external electronic device 804 may include an internet-of-things (IoT) device. The server 808 may be an intelligent server using machine learning and/or a neural network. According to an embodiment, the external electronic device 804 or the server 808 may be included in the second network 899. The electronic device 801 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 840) including one or more instructions that are stored in a storage medium (e.g., internal memory 836 or external memory 838) that is readable by a machine (e.g., the electronic device 801). For example, a processor (e.g., the processor 820) of the machine (e.g., the electronic device 801) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an embodiment, an electronic device may include a housing including a first surface facing a first direction, a second surface facing a second direction that is opposite to the first direction, and a side surface that at least partially surrounds a space between the first surface and the second surface, a first printed circuit board (PCB) disposed inside the housing, a second PCB disposed in parallel to the first PCB and including at least one electronic component on one surface thereof, an interposer disposed between the first PCB and the second PCB, a first connection member connected to a first ground of the first PCB, a second connection member connected to a second ground of the second PCB, and a conductor configured to come into electrical contact with the first connection member and the second connection member. The at least one electronic component may be electrically connected to the first ground via the second connection member, the conductor, and the first connection member.

According to an embodiment, the electronic device may include a wireless communication circuit disposed in the space.

According to an embodiment, the conductor may include a conductive pattern configured to transmit and receive a signal of a predetermined frequency band.

According to an embodiment, the wireless communication circuit may be configured to transmit and receive a signal of a first frequency band by feeding power to the conductive pattern.

The electronic device according to an embodiment may further include a filter circuit configured to block a signal of a second frequency band different from the first frequency band.

According to an embodiment, the electronic device may further include a structure coupled to one surface of the conductor, and an antenna pattern coupled to the structure.

According to an embodiment, the antenna pattern may be electrically connected to the first ground via the first connection member.

According to an embodiment, the structure may define at least a portion of the housing.

According to an embodiment, at least one of the first connection member and the second connection member may include a c-clip.

According to an embodiment, the at least one electronic component may include at least one of a radio frequency power amplifier module (RF PAM) or an attenuator.

According to an embodiment, the first PCB may have a first size, the second PCB may have a second size smaller than the first size, the first PCB may include a first area corresponding to the second PCB and a second area excluding the first area, and the first connection member may be connected to a third point of the first ground disposed in the second area of the first PCB.

According to an embodiment, an anti-noise electronic component configured not to generate noise may be disposed in the second area.

According to an embodiment, the first frequency band may include at least one of 850 MHz and 1.8 GHz.

According to an embodiment, the conductive pattern may include a laser direct structuring (LDS) antenna pattern.

An antenna module according to an embodiment may include a first printed circuit board (PCB) having a first size, a second PCB having a second size smaller than the first size and including at least one radio frequency (RF) electronic component on one surface, an interposer disposed between a first area of the first PCB corresponding to the second PCB and the second PCB, a first connection member connected to a first ground included in a second area excluding the first area in the first PCB, a second connection member connected to a second ground of the second PCB, and a first conductive pattern configured to come into electrical contact with the first connection member and the second connection member. According to an embodiment, the at least one RF electronic component may be electrically connected to the first ground via the second connection member, the first conductive pattern, and the first connection member.

According to an embodiment, the antenna module may include a structure in which the first conductive pattern is disposed and a second conductive pattern disposed in the structure.

According to an embodiment, the antenna module may include a wireless communication circuit, wherein the wireless communication circuit is configured to transmit and receive a signal in the first frequency band by feeding power to the first conductive pattern and to transmit and receive a signal in the second frequency band by feeding power to the second conductive pattern.

According to an embodiment, the antenna module may include a filter circuit including at least one inductor or capacitor to block a signal in a third frequency band different from the first frequency band and the second frequency band.

According to an embodiment, the first conductive pattern and the second conductive pattern may be electrically connected to at least one of the first ground and the second ground.

According to an embodiment, the first frequency band and the second frequency band may include at least one of 850 MHz and 1.8 GHz.

## Claims

1. An electronic device (100) comprising:
a housing (110) comprising a first surface (110A) facing a first direction, a second surface (110B) facing a second direction that is opposite to the first direction, and a side surface (110C) that at least partially surrounds a space between the first surface (110A) and the second surface (110B);
a first printed circuit board, PCB (331), disposed inside the housing (110);
a second PCB (332) disposed in parallel to the first PCB (331) and comprising at least one electronic component (450) on one surface thereof;
an interposer (340) disposed between the first PCB (331) and the second PCB (332);
a first connection member (421) connected to a first ground of the first PCB (331);
a second connection member (422) connected to a second ground of the second PCB (332);
a conductor (430) configured to come into electrical contact with the first connection member (421) and the second connection member (422), and
a structure (470) comprising an antenna pattern (620) disposed on a first side facing the first direction of the structure (470),
wherein the at least one electronic component (450) is electrically connected to the first ground via the second connection member (422), the conductor (430), and the first connection member (421), and
wherein the conductor (430) is disposed on at least a portion of a second side facing the second direction of the structure (470), and,
wherein the antenna pattern (620) is electrically connected to the first ground of the first PCB (331) via the conductor (430) and the first connection member (421).

2. The electronic device (100) of claim 1, further comprising a wireless communication circuit disposed in the space.

3. The electronic device (100) of claim 1 or claim 2, wherein the conductor (430) comprises a conductive pattern configured to transmit and receive a signal in a predetermined frequency band.

4. The electronic device (100) of claim 3, wherein the wireless communication circuit is configured to transmit and receive a signal in a first frequency band by feeding power to the conductive pattern.

5. The electronic device (100) of claim 4, further comprising a filter circuit (700) configured to block a signal in a second frequency band different from the first frequency band.

6. The electronic device (100) of claim 1, wherein the structure defines at least a portion of the housing (110).

7. The electronic device (100) of any one of claims 1 to 6, wherein at least one of the first connection member (421) and the second connection member (422) comprises a c-clip.

8. The electronic device (100) of any one of claims 1 to 7, wherein the at least one electronic component (450) comprises at least one of a radio frequency power amplifier module, RF PAM, or an attenuator.

9. The electronic device (100) of any one of claims 1 to 8, wherein the first PCB (331) has a first size and the second PCB (332) has a second size smaller than the first size,
the first PCB (331) comprises a first area corresponding to the second PCB (332) and a second area excluding the first area, and
the first connection member (421) is connected to a third point of the first ground disposed in the second area of the first PCB (331).

10. The electronic device (100) of claim 9, further comprising an anti-noise electronic component configured not to generate noise and disposed in the second area.

11. The electronic device (100) of claim 5, wherein the first frequency band includes at least one of 850 MHz and 1.8 GHz.

12. The electronic device (100) of claim 3, wherein the conductive pattern includes a laser direct structuring, LDS, antenna pattern.

13. An antenna module (360) comprising:
a first printed circuit board, PCB (331), having a first size;
a second PCB (332) having a second size smaller than the first size and comprising at least one radio frequency, RF, electronic component on one surface;
an interposer (340) disposed between a first area of the first PCB (331) corresponding to the second PCB (332) and the second PCB (332);
a first connection member (421) connected to a first ground comprised in a second area excluding the first area in the first PCB (331);
a second connection member (422) connected to a second ground of the second PCB (332);
a first conductive pattern configured to come into electrical contact with the first connection member (421) and the second connection member (422); and
a structure (470) comprising an antenna pattern (620) disposed on a first side facing a first direction of the structure (470),
wherein the at least one RF electronic component is electrically connected to the first ground via the second connection member (422), the first conductive pattern, and the first connection member (421),
wherein the first conductive pattern is disposed on at least portion of a second side facing a second direction opposite to the first direction of the structure (470), and
wherein the antenna pattern (620) is electrically connected to the first ground of the first PCB (331) via the first conductive pattern and the first connection member (421).

## Patentansprüche

1. Elektronische Vorrichtung (100), umfassend:
ein Gehäuse (110), das eine erste Fläche (110A), die in eine erste Richtung weist, eine zweite Fläche (110B), die in eine zweite Richtung weist, die der ersten Richtung entgegengesetzt ist, und eine Seitenfläche (110C) umfasst, die einen Raum zwischen der ersten Fläche (110A) und der zweiten Fläche (110B) zumindest teilweise umgibt;
eine erste Leiterplatte, PCB (331), die innerhalb des Gehäuses (110) angeordnet ist;
eine zweite PCB (332), die parallel zu der ersten PCB (331) angeordnet ist und mindestens eine elektronische Komponente (450) auf einer Fläche davon umfasst;
einen Interposer (340), der zwischen der ersten PCB (331) und der zweiten PCB (332) angeordnet ist;
ein erstes Verbindungselement (421), das mit einer ersten Erdung der ersten PCB (331) verbunden ist;
ein zweites Verbindungselement (422), das mit einer zweiten Erdung der zweiten PCB (332) verbunden ist;
einen Leiter (430), der konfiguriert ist, um in elektrischen Kontakt mit dem ersten Verbindungselement (421) und dem zweiten Verbindungselement (422) zu kommen, und
eine Struktur (470) , die ein Antennenmuster (620) umfasst, das auf einer ersten Seite, die in die erste Richtung weist, der Struktur (470) angeordnet ist,
wobei die mindestens eine elektronische Komponente (450) elektrisch mit der ersten Erdung über das zweite Verbindungselement (422), den Leiter (430) und das erste Verbindungselement (421) verbunden ist, und
wobei der Leiter (430) auf mindestens einem Abschnitt einer zweiten Seite, die in die zweite Richtung weist, der Struktur (470) angeordnet ist, und
wobei das Antennenmuster (620) elektrisch mit der ersten Erdung der ersten PCB (331) über den Leiter (430) und das erste Verbindungselement (421) verbunden ist.

2. Elektronische Vorrichtung (100) nach Anspruch 1, ferner umfassend eine drahtlose Kommunikationsschaltung, die in dem Raum angeordnet ist.

3. Elektronische Vorrichtung (100) nach Anspruch 1 oder Anspruch 2, wobei der Leiter (430) ein leitfähiges Muster umfasst, das zum Übertragen und Empfangen eines Signals in einem vorbestimmten Frequenzband konfiguriert ist.

4. Elektronische Vorrichtung (100) nach Anspruch 3, wobei die drahtlose Kommunikationsschaltung so konfiguriert ist, dass sie ein Signal in einem ersten Frequenzband überträgt und empfängt, indem sie das leitfähige Muster mit Leistung versorgt.

5. Elektronische Vorrichtung (100) nach Anspruch 4, ferner umfassend eine Filterschaltung (700), die so konfiguriert ist, dass sie ein Signal in einem zweiten Frequenzband, das sich von dem ersten Frequenzband unterscheidet, blockiert.

6. Elektronische Vorrichtung (100) nach Anspruch 1, wobei die Struktur mindestens einen Abschnitt des Gehäuses (110) definiert.

7. Elektronische Vorrichtung (100) nach einem der Ansprüche 1 bis 6, wobei mindestens eines von dem ersten Verbindungselement (421) und dem zweiten Verbindungselement (422) einen Sprengring umfasst.

8. Elektronische Vorrichtung (100) nach einem der Ansprüche 1 bis 7, wobei die mindestens eine elektronische Komponente (450) mindestens eines von einem Hochfrequenz-Leistungsverstärkermodul, RF-PAM oder einem Dämpfungsglied umfasst.

9. Elektronische Vorrichtung (100) nach einem der Ansprüche 1 bis 8, wobei die erste PCB (331) eine erste Größe aufweist und die zweite PCB (332) eine zweite Größe aufweist, die kleiner als die erste Größe ist,
die erste PCB (331) einen ersten Bereich, der der zweiten PCB (332) entspricht, und einen zweiten Bereich, der den ersten Bereich ausschließt, umfasst, und
das erste Verbindungselement (421) mit einem dritten Punkt der ersten Erdung verbunden ist, der im zweiten Bereich der ersten PCB (331) angeordnet ist.

10. Elektronische Vorrichtung (100) nach Anspruch 9, ferner umfassend eine rauschunterdrückende elektronische Komponente, die so konfiguriert ist, dass sie kein Rauschen erzeugt, und die in dem zweiten Bereich angeordnet ist.

11. Elektronische Vorrichtung (100) nach Anspruch 5, wobei das erste Frequenzband mindestens eines von 850 MHz und 1,8 GHz beinhaltet.

12. Elektronische Vorrichtung (100) nach Anspruch 3, wobei das leitfähige Muster ein Laserdirektstrukturierungs-, LDS, -Antennenmuster beinhaltet.

13. Antennenmodul (360), umfassend:
eine erste Leiterplatte, PCB (331), die eine erste Größe aufweist;
eine zweite PCB (332), die eine zweite Größe aufweist, die kleiner als die erste Größe ist, und die mindestens eine elektronische Hochfrequenz-, RF, -Komponente auf einer Fläche umfasst;
einen Interposer (340), der zwischen einem ersten Bereich der ersten PCB (331), der der zweiten PCB (332) entspricht, und der zweiten PCB (332) angeordnet ist;
ein erstes Verbindungselement (421), das mit einer ersten Erdung verbunden ist, die in einem zweiten Bereich, der den ersten Bereich in der ersten PCB (331) ausschließt, umfasst ist;
ein zweites Verbindungselement (422), das mit einer zweiten Erdung der zweiten PCB (332) verbunden ist;
ein erstes leitfähiges Muster, das konfiguriert ist, um in elektrischen Kontakt mit dem ersten Verbindungselement (421) und dem zweiten Verbindungselement (422) zu kommen; und
eine Struktur (470), die ein Antennenmuster (620) umfasst, das auf einer ersten Seite, die in eine erste Richtung weist, der Struktur (470) angeordnet ist,
wobei die mindestens eine elektronische RF-Komponente elektrisch mit der ersten Erdung über das zweite Verbindungselement (422), das erste leitfähige Muster und das erste Verbindungselement (421) verbunden ist,
wobei das erste leitfähige Muster auf mindestens einem Abschnitt einer zweiten Seite, die in eine zweite Richtung entgegengesetzt zur ersten Richtung weist, der Struktur (470) angeordnet ist, und
wobei das Antennenmuster (620) elektrisch mit der ersten Erdung der ersten PCB (331) über das erste leitfähige Muster und das erste Verbindungselement (421) verbunden ist.

## Revendications

1. Dispositif électronique (100), comprenant :
un boîtier (110) comprenant une première surface (110A) faisant face à une première direction, une deuxième surface (110B) faisant face à une deuxième direction qui est opposée à la première direction, et une surface latérale (110C) qui entoure au moins partiellement un espace entre la première surface (110A) et la deuxième surface (110B) ;
une première carte de circuit imprimé, PCB, (331) disposée dans le boîtier (110) ;
une deuxième PCB (332) disposée parallèlement à la première PCB (331) et comprenant au moins un composant électronique (450) sur une de ses surfaces ;
un interposeur (340) disposé entre la première PCB (331) et la deuxième PCB (332) ;
un premier élément de connexion (421) connecté à une première masse de la première PCB (331) ;
un deuxième élément de connexion (422) connecté à une deuxième masse de la deuxième PCB (332) ;
un conducteur (430) configuré pour entrer en contact électrique avec le premier élément de connexion (421) et le deuxième élément de connexion (422), et
une structure (470) comprenant un diagramme d'antenne (620) disposé sur un premier côté faisant face à la première direction de la structure (470),
dans lequel l'au moins un composant électronique (450) est connecté électriquement à la première masse via le deuxième élément de connexion (422), le conducteur (430), et le premier élément de connexion (421), et
dans lequel le conducteur (430) est disposé sur au moins une partie d'un deuxième côté faisant face à la deuxième direction de la structure (470), et
dans lequel le diagramme d'antenne (620) est connecté électriquement à la première masse de la première PCB (331) via le conducteur (430) et le premier élément de connexion (421).

2. Dispositif électronique (100) de la revendication 1, comprenant en outre un circuit de communication sans fil dans l'espace.

3. Dispositif électronique (100) de la revendication 1 ou de la revendication 2, dans lequel le conducteur (430) comprend un motif conducteur configuré pour transmettre et recevoir un signal dans une bande de fréquence prédéterminée.

4. Dispositif électronique (100) de la revendication 3, dans lequel le circuit de communication sans fil est configuré pour transmettre et recevoir un signal dans une première bande de fréquence en alimentant en énergie le motif conducteur.

5. Dispositif électronique (100) de la revendication 4, comprenant en outre un circuit de filtrage (700) configuré pour bloquer un signal dans une deuxième bande de fréquence différente de la première bande de fréquence.

6. Dispositif électronique de la revendication 1, dans lequel la structure définit au moins une partie du boîtier (110).

7. Dispositif électronique (100) selon l'une quelconque des revendications 1 à 6, dans lequel au moins l'un du premier élément de connexion (421) et du deuxième élément de connexion (422) comprend un clip en C.

8. Dispositif électronique (100) de l'une quelconque des revendications 1 à 7, dans lequel l'au moins un composant électronique (450) comprend au moins l'un parmi un module amplificateur de puissance radio-fréquence, PAM RF, ou un atténuateur.

9. Dispositif électronique (100) de l'une quelconque des revendications 1 à 8, dans lequel la première PCB (331) présente une première taille et la deuxième PCB (332) présente une deuxième taille inférieure à la première taille,
la première PC (331) comprend une première zone correspondant à la deuxième PCB (332) et une deuxième zone excluant la première zone, et
le premier élément de connexion (421) est connecté à un troisième point de la première masse disposé dans la deuxième zone de la première PCB (331).

10. Dispositif électronique (100) de la revendication 9, comprenant en outre un composant électronique anti-bruit configuré pour ne pas générer de bruit et disposé dans la deuxième zone.

11. Dispositif électronique (100) de la revendication 5, dans lequel la première bande de fréquences comprend au moins l'un de 850 MHz et de 1,8 GHz.

12. Dispositif électronique (100) de la revendication 3, dans lequel le motif conducteur comprend un diagramme d'antenne à structuration directe par laser, LDS.

13. Module d'antenne (360), comprenant :
une première carte de circuit imprimé, PCB, (331) ayant une première taille ;
une deuxième PCB (332) ayant une deuxième taille inférieure à la première taille et comprenant au moins un composant électronique de radio-fréquence, RF, sur une surface ;
un interposeur (340) disposé entre une première zone de la première PCB (331) correspondant à la deuxième PCB (332) et la deuxième PCB (332) ;
un premier élément de connexion (421) connecté à une première masse comprise dans une deuxième zone excluant la première zone dans la première PCB (331) ;
un deuxième élément de connexion (422) connecté à une deuxième masse de la deuxième PCB (332) ;
un premier motif conducteur configuré pour entrer en contact électrique avec le premier élément de connexion (421) et le deuxième élément de connexion (422) ; et
une structure (470) comprenant un diagramme d'antenne (620) disposé sur un premier côté faisant face à une première direction de la structure (470),
dans lequel l'au moins un composant électronique RF est connecté électriquement à la première masse par l'intermédiaire du deuxième élément de connexion (422), du premier motif conducteur et du premier élément de connexion (421),
dans lequel le premier motif conducteur est disposé sur au moins une partie d'un deuxième côté faisant face à une deuxième direction opposée à la première direction de la structure (470), et
dans lequel le diagramme d'antenne (620) est connecté électriquement à la première masse de la première PCB (331) par l'intermédiaire du premier motif conducteur et du premier élément de connexion (421).
